# FASCICULE DE BREVET EUROPEEN

(11) **EP 1 359 615 B1**
(45) Date de publication et mention de la délivrance du brevet: **29.10.2008**
(21) Numéro de dépôt: 03291052.3
(22) Date de dépôt: 30.04.2003
(51) Int. Cl.: H01L 21/762

(54) **Procédé de décollement de couches de matériau**
Delaminationsverfahren von Materialschichten
Method of delaminating material layers

(30) Priorité: 02.05.2002 FR 0205500
(43) Date de publication de la demande: 05.11.2003
(73) Titulaire: S.O.I.Tec Silicon on Insulator Technologies, 38190 Bernin (FR)
(72) Inventeur: Schwarzenbach, Walter, 38330 Saint Nazaire Les Eymes (FR); Maleville, Christophe, 38660 La Terrasse (FR)
(74) Mandataire: Texier, Christian

(56) Documents cités:
- EP-A- 0 954 014
- US-B1- 6 211 041
- US-B1- 6 303 468
- US-B1- 6 368 938

## Description

La présente invention concerne de manière générale le traitement des matériaux, et plus particulièrement de substrats pour l'électronique, l'optique ou l'optroélectronique.

Plus précisément, l'invention concerne un procédé de décollement de deux couches de matériau selon une surface de fragilisation définie entre les deux couches, le procédé comprenant un recuit thermique d'une structure comprenant lesdites couches, le recuit amenant la température d'une température de début de recuit à une température de fin de recuit.

On connaît déjà des procédés du type mentionné ci-dessus.

Le document US 6,211,041 décrit une méthode de fabrication d'un substrat "silicium-sur-isolant" (SOI) avec un traitement thermique comportant deux phases.

En particulier, il est connu d'appliquer de tels procédés connus pour réaliser le décollement de deux couches de matériau provenant d'un même substrat, entre lesquelles on a préalablement défini une surface de fragilisation par implantation d'espèces dans le substrat.

Les espèces implantées peuvent être des ions ou des atomes. Il est ainsi connu d'implanter un substrat d'un matériau semiconducteur tel que le silicium avec une espèce telle que l'hydrogène ou l'hélium.

Et la surface de fragilisation est déterminée en fonction de la nature du matériau, de la nature des espèces implantées et de l'énergie d'implantation (cette surface de fragilisation étant typiquement un plan parallèle à la face d'implantation du substrat).

Il est également possible de réaliser la surface de fragilisation par tout autre moyen connu en soi, par exemple en construisant une région intermédiaire de matériau poreux entre deux régions de matériau dense, en constituant une couche d'oxyde enterrée dans un substrat (par exemple un substrat de type SOI), ou encore en effectuant un collage de deux couches, la zone de collage correspondant alors à la surface de fragilisation.

Un tel décollement de deux couches séparées par une surface de fragilisation peut être mis en oeuvre pour réaliser des couches minces (dont l'épaisseur peut être comprise entre une fraction de micron et plusieurs microns), comme cela est décrit par exemple dans le document FR 2 681 472.

Ce document décrit en effet un procédé connu sous le nom générique de SMARTCUT®, qui a pour but de fabriquer des structures de type SOI (Silicon On Insulator selon la terminologie anglo-saxonne répandue). Les étapes majeures de ce procédé sont les suivantes :
- Oxydation d'une plaque dite supérieure de silicium, pour créer une couche d'oxyde (qui correspond à la couche d'oxyde enterré de la structure SOI),
- Implantation ionique d'hydrogène dans cette plaque supérieure afin de créer la surface de fragilisation, et de délimiter par cette surface d'une part la structure SOI (se trouvant du côté de l'oxyde enterré), et d'autre part un reliquat de silicium,
- Collage de la plaque supérieure sur une plaque support appelée raidisseur (qui peut être réalisé en silicium, mais également dans un autre matériau),
- Recuit en vue de réaliser un décollement pour obtenir d'une part une structure SOI comprenant la plaque support, la couche d'oxyde enterrée et la couche de silicium située entre l'oxyde enterré et la surface de fragilisation, et d'autre part le reliquat de silicium situé de l'autre côté de la surface de fragilisation.
   On précise à cet égard que ce recuit peut :
   ➢ soit permettre de réaliser complètement le décollement, le SOI et le reliquat sortant effectivement décollés du four de recuit,
   ➢ soit, si le budget thermique n'est pas suffisant pour réaliser complètement le recuit, ne permettre de réaliser qu'un clivage entre le SOI et le reliquat. Le « clivage » correspond à un état précédant le décollement dans lequel le SOI et le reliquat sont encore reliés par des liaisons de type forces de Van der Waals, ou encore par un simple effet ventouse des deux parties à décoller.
   Dans ce cas, on finalise après recuit le décollement, par exemple par apport d'énergie mécanique (introduction d'un élément saillant tel qu'une lame au niveau de la surface de fragilisation, ...),
- Traitement complémentaire destiné à réduire la rugosité de la surface du SOI qui est issue du clivage et du décollement. Il est ainsi courant de trouver des spécifications de rugosité ne devant pas dépasser 5 Angströms en valeur rms (correspondant à l'acronyme anglo-saxon « root mean square »).

On précise que les mesures de rugosité sont généralement effectuées grâce à un microscope à force atomique (AFM selon l'acronyme qui correspond à l'appellation anglo-saxonne de Atomic Force Microscope).

Avec ce type d'appareil, la rugosité est mesurée sur des surfaces balayées par la pointe du microscope AFM, allant de 1x1 µm² à 10x10 µm² et plus rarement 50x50 µm², voire 100x100 µm².

On précise également qu'il est possible de mesurer la rugosité de surface par d'autres méthodes, en particulier par le biais d'une mesure de « haze » selon la terminologie anglo-saxonne répandue.

Cette méthode présente en particulier l'avantage de permettre de caractériser rapidement l'uniformité de la rugosité sur toute une surface.

Ce haze, mesuré en ppm, est issu d'une méthode utilisant les propriétés de réflectivité optique de la surface à caractériser, et correspond à un « bruit de fond » optique diffusé par la surface, en raison de sa micro-rugosité.

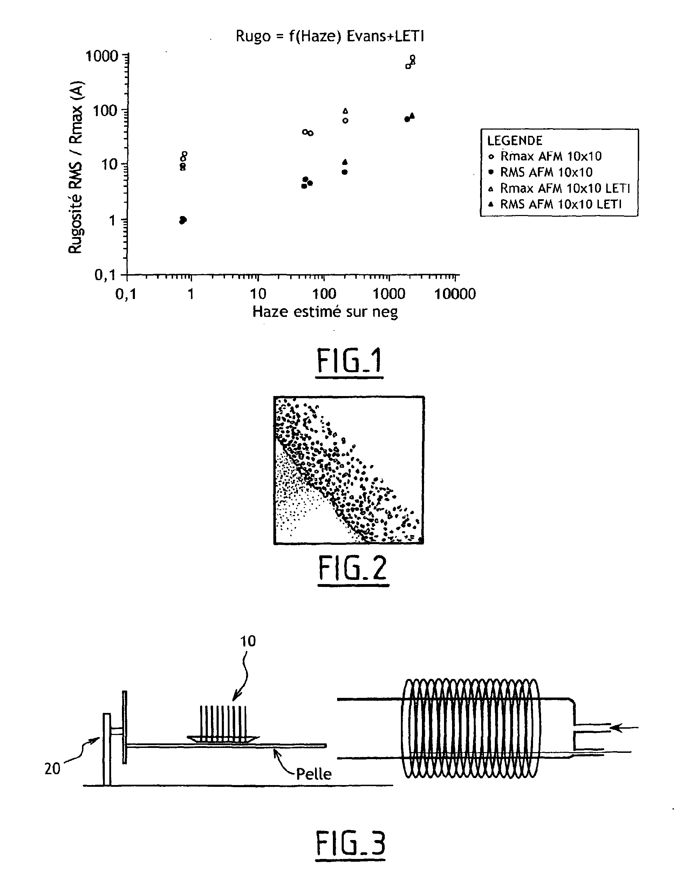

Un exemple de lien entre le haze et la rugosité est représenté, dans le cas de la surface d'un SOI, sur la figure 1.

On précise que le procédé de type SMARTCUT® peut également être mis en oeuvre pour constituer des structures autres que des SOI, par exemple des SOA (Silicon On Anything selon la terminologie anglo-saxonne répandue: silicium sur un matériau quelconque), ou même des AOA (Anything On Anything selon la terminologie anglo-saxonne répandue : matériau quelconque sur un matériau quelconque).

Les procédés connus de décollement par recuit mettent généralement en oeuvre un recuit amenant la structure comprenant les deux couches à décoller d'une température de début de recuit relativement basse, qui peut être par exemple de l'ordre de 350°C, à une température de décollement plus élevée mais n'excédant pas une valeur de l'ordre de 500°C, avec dans le four de recuit une évolution de température selon une croissance sensiblement constante, de l'ordre de 10°C par minute.

La température de décollement correspond pour ces recuits de décollement de l'état de la technique à la température de fin de recuit.

Ainsi, les recuits de décollement connus sont effectués avec une évolution de température selon une rampe de température sensiblement constante, la pente de cette rampe étant de l'ordre de 10°C/min.

Mais on observe fréquemment que les surfaces issues du décollement (c'est à dire les surfaces des deux couches se faisant face de part et d'autre de la surface de fragilisation) présentent une rugosité relativement élevée.

Et des traitements spécifiques relativement importants peuvent être rendus nécessaires, afin d'obtenir l'état de surface désiré pour les surfaces issues du décollement.

Par exemple, dans le cas du décollement de couches d'une plaque de matériau tel que le silicium pour constituer un SOI, on obtient généralement en sortie de décollement des rugosités de l'ordre de 80 Angströms rms (en mesure AFM sur un champ de 10*10 microns).

Le but principal de l'invention est donc de permettre de réaliser des recuits de décollement produisant un état de surface amélioré des surfaces issues du décollement.

Et en fonction de ce qui précède, selon un premier aspect particulier l'invention vise plus particulièrement à permettre de diminuer la rugosité des surfaces issues du décollement, par rapport aux procédés connus.

Par ailleurs, avec les procédés de recuit de décollement connus, on observe également une dégradation de la structure périphérique des structures à décoller.

La figure 2 représente ainsi le résultat typique d'une observation au microscope du bord périphérique de la surface d'un SOI après son décollement par un recuit selon l'état de la technique, la région périphérique étant nommée « couronne ».

Cette observation fait apparaître de nombreuses irrégularités de structure dans la couronne du SOI.

Cette figure illustre ainsi la dégradation de la couronne du SOI, ladite dégradation étant conséquente au recuit de décollement (ceci étant applicable à des structures d'autres types que le SOI).

L'invention vise également à éviter, ou tout au moins à réduire, une telle dégradation constatée suite au décollement par recuit.

Afin d'atteindre ces buts, l'invention propose selon un premier aspect un procédé de décollement de deux couches de matériau selon une surface de fragilisation définie entre les deux couches, le procédé comprenant un recuit thermique d'une structure (10) comprenant lesdites couches, le recuit amenant la température d'une température de début de recuit à une température de fin de recuit, caractérisé en ce que lors du recuit thermique on fait évoluer la température de recuit selon une première phase jusqu'à une température de transition, puis selon une deuxième phase lors de laquelle la croissance de la température par unité de temps est plus forte que lors de la première phase.

Des aspects préférés, mais non limitatifs de ce procédé sont les suivants :
- la température de transition correspond à un début de décollement,
- la première phase est une phase d'initiation du décollement, et la deuxième phase est une phase de finition d'état de surface,
- la deuxième phase est suivie d'un palier de chauffage à une température sensiblement constante,
- ladite température sensiblement constante correspond à la température de fin de recuit,
- lors de la première phase la température augmente selon une pente moyenne lente, pouvant aller jusqu'à environ 10°C/min,
- lors de la deuxième phase la température augmente selon une pente moyenne rapide, supérieure à environ 15°C/min,
- la température de début de recuit est inférieure ou égale à 350°C,
- la température de fin de recuit est de l'ordre de 500°C à 800°C,
- la température de fin de recuit est de l'ordre de 600°C,
- la température de transition entre les deux phases est de l'ordre de 430°C à 450°C,

Selon un deuxième aspect, l'invention propose également l'application d'un procédé selon un des aspects ci-dessus pour décoller deux couches de matériau délimitées par une surface de fragilisation, ladite surface de fragilisation ayant été réalisée dans le cadre d'un procédé de type SMARTCUT®.

Des aspects préférés, mais non limitatifs d'une telle application sont les suivants :
- les deux couches de matériau comprennent une couche de silicium,
- les deux couches de matériau sont deux couches de silicium, une des deux couches correspondant à un SOI, l'autre couche correspondant à un reliquat de silicium

D'autres aspects, buts et avantages de l'invention apparaîtront mieux à la lecture de la description suivante d'une forme de réalisation de l'invention, faite en référence aux dessins annexés sur lesquels, outre les figures 1 et 2 qui ont déjà été commentées en référence à l'état de la technique :
- La figure 3 représente schématiquement un four de recuit, mis en oeuvre pour réaliser l'invention,
- La figure 4a représente la répartition spatiale de haze à la surface d'un SOI ayant subi un recuit de décollement selon l'état de la technique,
- la figure 4b est un graphe représentant globalement la répartition de haze à la surface du SOI pour la surface duquel la figure 4a illustre la répartition spatiale de haze, le graphe de la figure 4b permettant en particulier d'identifier le haze moyen à la surface considérée,
- la figure 5 représente graphiquement l'évolution de température lors d'un recuit de décollement effectué selon l'état de la technique, et le même type d'évolution pour deux recuits de décollement réalisés selon l'invention,
- la figure 6 représente de manière très schématique le collage d'une tranche de silicium oxydée et implantée, et d'un raidisseur, dans un procédé de type SMARTCUT®,
- les figures 7a, 8a et 9a représentent visuellement la répartition spatiale du haze à la surface de trois SOI après leur décollement par recuit, le SOI de la figure 7a ayant subi un recuit de décollement standard, les deux SOI des figures 8a et 9a ayant subi des recuits de décollement selon l'invention effectués selon des modalités différentes,
- les figures 7b, 8b et 9b sont des graphes similaires à ceux de la figure 4b représentant globalement la répartition de haze pour les SOI et respectifs des figures 7a, 8a et 9a (la figure 7b correspondant comme la figure 4b à un SOI recuit selon une technique connue),
- les figures 10 à 12 sont trois représentations similaires d'une observation au microscope du bord périphérique de trois SOI respectifs ayant subi un recuit de décollement,
   ○ la figure 10 correspondant à un SOI ayant subi un recuit standard (et étant similaire à la figure 2),
   ○ les figures 11 et 12 correspondant aux SOI respectifs des figures (8a, 8b) et (9a, 9b),

Préalablement à la description qui suit, on précise que dans le cas de structures telles que des substrats multicouches comprenant comme évoqué ci-dessus un SOI (ou SOA, ou même AOA) et une couche de reliquat de matériau (de silicium dans le cas d'un SOI), la forme de la structure est généralement celle d'une très fine galette que l'on désigne par le terme de « wafer » selon la terminologie anglo-saxonne répandue.

Et les wafers sont ainsi disposés verticalement dans le four, comme cela est représenté sur la figure 3 (les wafers à décoller étant désignés par la référence 10, le four étant désigné par la référence 20).

Cette disposition verticale des wafers vise à prévenir les risques de déplacements des deux couches décollées de chaque wafer, l'une par rapport à l'autre, à la fin du décollement dans le four ou surtout lors des opérations de manutention pour sortir les wafers décollés du four.

On a en effet vu ci-dessus que les spécifications d'état de surface étaient dans certains cas drastiques (en particulier pour un SOI) : il est donc nécessaire de prévenir tout déplacement relatif des deux couches décollées, afin d'éviter les risques de rayures sur les surfaces des deux couches décollées.

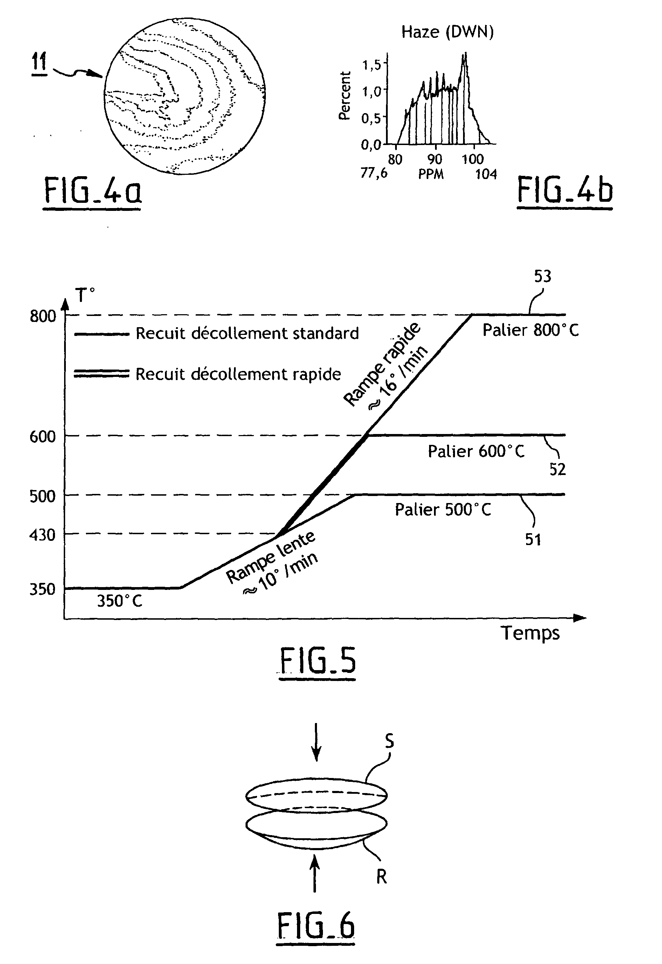

On notera en outre que, comme représenté sur la figure 4a, la rugosité de surface d'un SOI 11 issu d'un recuit de décollement présente une dissymétrie.

On observe en effet sur cette figure une zone de la surface du SOI (située entre 9 et 10 heures) dans laquelle le haze, et partant la rugosité, sont augmentés.

Une telle inhomogénéité résulte de la présence de points chauds dans le four de recuit. Dans le cas d'un four tel que représenté en figure 3, il s'agit plus précisément de la traduction du gradient de température vertical (les wafers à décoller étant placés dans le four avec une orientation de 90° par rapport à la représentation de la figure 4a).

En référence maintenant à la figure 4b, on a représenté la répartition globale de haze sur la surface du SOI de la figure 4a.

On rappelle que ce SOI a subit un recuit de décollement selon un procédé connu dans l'état de la technique.

La figure 4b illustre que la valeur du haze moyen sur la totalité de SOI est de l'ordre de 87 ppm.

Cette valeur est directement liée à une valeur de rugosité moyenne de ce SOI, et représente ainsi une valeur de référence pour la mesure d'une rugosité de SOI, caractérisée par la mesure de haze.

On précise que cette mesure de haze, ainsi que les mesures similaires qui seront exposées plus loin dans ce texte, sont effectuées selon le même protocole et par le même dispositif, en l'occurrence par un instrument de type KLA Tencor Surfscan SPI (marque déposée).

En référence maintenant à la figure 5, on a représenté schématiquement l'évolution en fonction du temps de la température régnant dans le four de recuit, lors de trois recuits de décollement.

Plus précisément, cette figure comprend trois courbes 51, 52, 53 qui correspondent à trois types de recuits différents.

Le début de l'évolution de température lors de ces trois recuits est identique, se composant d'un palier d'entrée à 350°C (correspondant à la température d'entrée de recuit), suivi d'une rampe de montée d'une température ayant une pente de l'ordre de 10°C par minute (ou moins), comme cela est connu dans l'état de la technique.

Sur la partie droite de la figure, on constate cependant qu'au cours du temps les températures des trois recuits évoluent différemment.

Plus particulièrement, la courbe 51 illustre l'évolution d'un recuit de décollement selon l'état de la technique.

Dans un tel recuit, après avoir été maintenue au niveau d'entrée de 350°C pendant un premier palier, la température évolue selon la rampe connue de pente de l'ordre de 10°C par minute, jusqu'à une température de décollement et de fin de recuit de l'ordre de 500°C.

On précise toutefois que la température dite de « début de décollement », à partir de laquelle on peut observer le déclenchement du décollement, peut avoir une valeur de l'ordre de 430°C à 450°C.

La température d'entrée de recuit peut avoir une valeur inférieure à 350°C (cela sera également le cas pour les recuits selon l'invention, illustés par les courbes 52 et 53).

La fin de ce recuit comporte un deuxième palier, à cette température de fin de recuit.

Dans le cas de ce recuit connu, l'évolution de température se fait donc selon une rampe unique.

La courbe 52 représente quant à elle l'évolution de température d'un recuit effectué selon l'invention, dans une première variante.

On constate dans ce cas qu'après avoir emprunté une partie de la rampe standard ayant une pente de l'ordre de 10°C par minute (ou moins), une fois que la température a été amenée à une valeur de transition de l'ordre de 430°C à 450°C , la température évolue selon une deuxième rampe dont la pente est différente de celle de la première rampe.

Les deux rampes sont représentées sensiblement rectilignes.

Plus précisément, la deuxième rampe a une pente sensiblement supérieure à celle de la première rampe, la pente de cette deuxième rampe étant de l'ordre de 16°C par minute.

On précise toutefois que pour ce recuit selon l'invention, ainsi que pour le recuit représenté par la courbe 53, les deux rampes rectilignes peuvent être remplacées par deux rampes non rectilignes correspondant à la même évolution générale en deux phases séparées par une température de transition, la deuxième phase correspondant à une montée en température plus rapide.

Le recuit se termine par un palier à la température de fin de recuit de l'ordre de 600°C.

La courbe 53 illustre une variante de l'invention, dans laquelle la deuxième rampe a ici encore une pente de l'ordre de 16° par minute après une transition vers 430°C à 450°C.

Dans ce cas, la deuxième rampe se prolonge jusqu'à une température de fin de recuit à une valeur encore supérieure, de l'ordre de 800°C

Ainsi, les recuits de décollement selon l'invention qui correspondent aux courbes 52 et 53 sont pratiqués avec une montée de température comprenant deux phases ayant des rampes moyennes respectives différentes (ces rampes pouvant être rectilignes, ou non) :
- une phase « lente », dont la rampe moyenne peut avoir une pente moyenne relativement faible, de l'ordre de 10°C/min ou moins,
- suivie d'une phase « rapide », de pente moyenne augmentée (pouvant être de l'ordre de 15°C/min ou plus), cette deuxième phase étant destinée à finaliser le décollement et à permettre d'aboutir comme cela va être expliqué à un état de surface amélioré.

Plus précisément, la première phase correspond à une rampe de recuit de décollement classique.

Cette première phase a dans le cas de l'invention pour but d'apporter au wafer à décoller un apport d'énergie thermique conduisant « presque » au décollement.

Plus précisément encore, la première phase s'arrête à une température de transition qui correspond à un début de décollement suite à l'énergie thermique apportée au wafer lors de la première phase.

Par « début de décollement » on entend l'état dans lequel une partie de la surface de fragilisation a effectivement subi un décollement, mais ce décollement ne s'étant pas propagé à toute la surface de fragilisation.

Il s'agit ainsi d'un état dans lequel le wafer comporte une « bulle » de décollement, au niveau de sa surface de fragilisation.

Dans un recuit classique (tel que celui représenté par la courbe 51), on poursuit au-delà de ce début de décollement la rampe selon la même pente moyenne, pour finaliser le décollement (dans le cas où on désire réaliser entièrement le décollement lors du recuit).

Dans le cas de l'invention au contraire, on augmente la pente de l'évolution de température de manière à poursuivre le recuit en une deuxième phase correspondant à une deuxième rampe, sensiblement supérieure à la pente de la première phase.

On précise que la température de transition, qui est comme on l'a vu la température correspondant au début de décollement, sera adaptée en fonction de la nature et des dimensions du wafer à décoller; cette adaptation pourra se faire selon des abaques, ou de manière empirique.

A cet égard, notons par ailleurs que la « température de transition » correspond plus précisément à un « budget thermique de transition » apporté au wafer, qui correspond lui-même à un état du wafer dans lequel on obtient dans la surface de fragilisation du wafer un début de décollement.

La deuxième phase a pour but de finaliser le décollement, en permettant d'aboutir à un état de surface (rugosité notamment) sensiblement amélioré par rapport à ce qui est obtenu de manière connue.

La Demanderesse a en effet observé qu'en faisant suivre la première phase, après une température de transition telle que définie et précisée ci-dessus, par une deuxième phase de pente moyenne sensiblement augmentée, on obtient un état de surface des couches décollées qui est sensiblement amélioré par rapport à ce qui est obtenu en sortie de recuit de décollement dans l'état de la technique.

Précisons également que la deuxième phase, outre le fait qu'elle présente une pente moyenne augmentée, amène en outre de préférence le wafer à une température de fin de recuit également sensiblement augmentée par rapport à la température de fin de recuit de décollement selon l'état de la technique (qui sont de l'ordre de 500°C comme illustré par la courbe 51).

Ceci est illustré par les températures de fin de recuit des courbes 52 et 53.

Et cette caractéristique, combinée à la forte pente moyenne associée à la deuxième phase, permet en effet d'obtenir un état de surface particulièrement intéressant, la rugosité de surface des couches décollées diminuant alors encore.

Pour initier un décollement en un endroit spécifique de la surface de fragilisation du wafer, on pourra exploiter les inhomogénéités de température régnant à l'intérieur du four (par exemple présence de gradients thermiques dans un four à l'intérieur duquel les wafers sont disposés verticalement).

On précise que dans le cas où le wafer à décoller a été constitué par le collage de deux tranches ayant des caractéristiques mécaniques différentes, les comportements mécaniques respectifs des deux tranches collées influent également sur le décollement des couches.

Ceci est le cas par exemple pour les SOI élaborés selon un procédé de type SMARTCUT®, les SOI étant obtenus par décollement, au niveau d'une surface de fragilisation (constituée par implantation), du SOI et du reliquat de silicium.

On précise à cet égard que si on parle de « décollement », le décollement ne désigne pas ici l'opération consistant à défaire une liaison qui avait été réalisée par collage (« bonding » selon la terminologie anglo-saxonne répandue).

Ainsi, dans le cas du « décollement » d'un wafer pour constituer un SOI, on a constitué par collage (entre la plaque de silicium oxydée et implantée, et le raidisseur) une interface de collage, et on décolle au niveau de la surface de fragilisation réalisée par implantation, cette surface de fragilisation étant distincte de l'interface de collage même si elle en est très proche.

Dans ce cas, les deux « couches » à décoller sont ainsi d'une part le SOI lui-même qui comporte le raidisseur, l'oxyde et la fine tranche de silicium, et d'autre part le reliquat de silicium.

Etant données l'extrême finesse de l'oxyde et de la fine tranche de silicium du SOI, le SOI a des caractéristiques mécaniques qui sont assimilables à celles du raidisseur, de sorte que les deux « couches » à décoller ont les caractéristiques mécaniques respectives du silicium et du raidisseur (qui peuvent être de natures différentes, le raidisseur pouvant être réalisé en silicium, mais également dans des matériaux les plus divers - quartz par exemple).

Du point de vue des caractéristiques mécaniques, on peut donc assimiler respectivement chacune des deux couches à décoller du SOI à deux tranches qui ont été préalablement collées pour constituer le wafer à « décoller » (la tranche de silicium, et le raidisseur).

Ce qui va suivre immédiatement s'applique ainsi au décollement (c'est à dire fracture de l'interface de fragilisation préalablement réalisée) de deux couches qui sont assimilables de la même manière à deux tranches qui ont été préalablement collées, chacune des deux couches à décoller étant essentiellement composée du matériau d'une de ces deux tranches.

Et revenant de manière générale à l'influence du comportement mécanique des couches à décoller, on précise que les deux couches à décoller du SOI (le reliquat de silicium, et le SOI lui-même) peuvent ainsi avoir des caractéristiques mécaniques différentes).

En outre, ces deux couches sont comme on vient de le voir équivalentes du point de vue mécanique à une tranche de silicium, et au raidisseur (ces deux éléments ayant été assemblés par collage).

On précise que les deux tranches ainsi collées ne sont pas exactement planes.

Il existe en effet des tolérances sur la planéité de telles tranches.

Et le collage des deux tranches (silicium oxydé et implanté S, et raidisseur R - voir figure 6) a été réalisé de manière à ce que les concavités des deux tranches respectives se fassent face, comme cela est représenté schématiquement sur la figure.

On précise que sur cette figure les concavités des deux tranches collées ont été représentées beaucoup plus profondes qu'en réalité, et ne correspondent aucunement à l'échelle réelle.

Lors d'un tel collage, les concavités des deux tranches sont « écrasées » de manière à coller les surfaces des deux tranches ensemble. Les deux tranches du wafer ainsi constitué (et partant les deux couches à « décoller », étant donné qu'on a vu que mécaniquement ces deux couches étaient équivalentes aux deux tranches collées) sont donc légèrement précontraintes en rapprochement l'une de l'autre (surtout dans leur région centrale).

Ces deux couches tendront donc à s'écarter l'une de l'autre dès qu'un décollement aura été initié entre elles, en un mouvement de relaxation des contraintes dues au collage mentionnées ci-dessus.

Et ceci favorise la poursuite du décollement après le décollement initial décrit ci-dessus et obtenu à l'issue de la première phase de recuit.

On précise que ce phénomène de relaxation entre en oeuvre pour le décollement selon l'invention de tout wafer dont les deux couches à décoller sont assimilables à deux tranches qui ont été préalablement collées, en subissant une précontrainte en rapprochement l'une de l'autre.

Revenant au procédé selon l'invention de manière générale, on a dit que les températures de fin de recuit sont supérieures aux températures de fin de recuit de l'état de la technique.

Plus précisément, dans une variante préférée de l'invention on obtiendra des résultats avantageux avec des températures de fin de recuit de l'ordre de 500°C à 800°C.

Et plus précisément encore, selon une option préférée de mise en oeuvre de l'invention la température de fin de recuit est de l'ordre de 600°C.

On précise que la pente de la deuxième rampe qui est dite rampe « rapide », n'est pas obligatoirement de 16°C par minute. Cette valeur non limitative peut être adaptée ; en tout état de cause elle doit être sensiblement supérieure à la valeur de la pente de la première rampe de montée de la température.

De même, la température de fin de recuit, si elle sera effectivement choisie de préférence sensiblement plus élevée que pour des recuits de décollement classique, n'est pas limitée aux valeurs décrites ci-dessus qui ne constituent que des valeurs préférées.

On précise également que le profil de montée en température en deux rampes rectilignes qui est représenté sur les courbes 52 et 53 ne constitue qu'un mode particulier de mise en oeuvre de l'invention.

En effet, une caractéristique générale d'un tel recuit effectué selon l'invention est qu'il comporte :
- Une première phase lors de laquelle on amène la température d'une température de début de recuit (qui peut avoir comme on l'a dit une valeur inférieure à 350°C) à une température correspondant à une température de début de décollement du wafer.
   On précise que le début de décollement peut par exemple être observé en suivant par tout moyen connu en soi le diamètre de bulles gazeuses générées par le recuit de décollement à partir d'une surface de fragilisation définie par implantation, les bulles gazeuses provenant de la coalescence des micro-cavités formées dans la structure par les espèces implantées.
   Cette première phase correspond à la première rampe « lente » des courbes 52 et 53,
- Suivie d'une deuxième phase lors de laquelle, au lieu de stabiliser la température comme dans les recuits de décollement connus, à une température de fin de recuit correspondant à une température qui n'est que faiblement supérieure à la température de début de décollement, non seulement on poursuit au contraire la montée en température, mais on augment même la croissance de la température par unité de temps.

On peut ainsi considérer que :
- la première phase correspond au déclenchement mécanique du décollement,
- alors que la deuxième phase de recuit intensif permet :
   ➢ non seulement de finaliser ce décollement,
   ➢ mais encore d'obtenir (comme cela va être exposé plus en détail plus loin dans ce texte) un très bon état de surface, cette deuxième phase correspondant ainsi à une phase de finition.

On précise également que la température de début de décollement, qui correspond à la température de transition entre les deux phases du recuit peut varier en fonction des caractéristiques de la structure à décoller.

En effet, la valeur de 430°C à 450°C mentionnée ci-dessus n'est pas strictement limitative: en fonction de caractéristiques telles que le(s) matériau(x) de la structure, la dose et l'énergie d'implantation utilisée lors de la création de la surface de fragilisation (dans le cas où cette surface a été créée par implantation), cette température peut varier dans une certaine mesure.

Par exemple, si l'on crée la surface de fragilisation par implantation, le budget thermique devant être apporté pour provoquer un bullage de début de décollement doit être adapté lorsqu'on modifie l'énergie d'implantation.

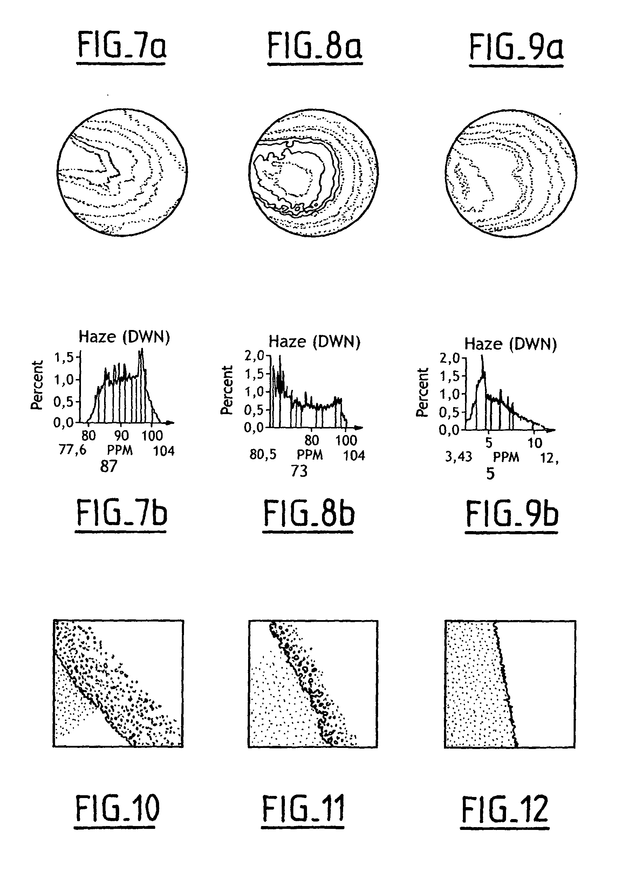

Les figures 7a à 9a illustrent les différences de répartition spatiale de haze à la surface de trois SOI qui ont subi des recuits de décollement selon trois modalités différentes.

La figure 7a représente ainsi la répartition de haze à la surface d'un SOI ayant subit un recuit de décollement classique, correspondant à la courbe 51 de la figure 5.

Cette figure est à rapprocher de la figure 7b, qui, à l'instar de la figure 4b, illustre une répartition globale de haze sur la surface du SOI, et une valeur moyenne de l'ordre de 87ppm.

La figure 8a représente quant à elle la répartition spatiale de haze à la surface d'un SOI ayant subit un recuit de décollement selon l'invention, avec une évolution de température correspondant à la courbe 52 de la figure 5.

Cette figure est à rapprocher de la figure 8b, dont on déduit une valeur de haze moyen de l'ordre de 73ppm sur la surface du SOI.

On constate ainsi une diminution sensible de la valeur du haze moyen et, partant, de la rugosité à la surface du SOI issu du décollement.

Les figures 9a et 9b correspondent à un autre SOI, ayant subi un recuit de décollement selon une évolution de température conforme à la courbe 53 de la figure 5.

Dans ce cas, comme représenté plus particulièrement sur la figure 8b, la valeur moyenne de haze à la surface du SOI est de l'ordre de 5ppm.

Ceci correspond donc à une diminution extrêmement importante de la rugosité de surface du SOI.

Les figures 10 à 12 illustrent quant à elles l'évolution de l'état de la couronne de trois SOI respectifs ayant subi des recuits de décollement selon les trois modalités respectives décrites ci-dessus (correspondant aux trois courbes respectives 51, 52, 53 de la figure 5).

Ces figures 10 à 12 illustrent une diminution importante de la dégradation périphérique de la structure du SOI (la structure la plus dégradée correspondant à un recuit classique, la structure la plus préservée correspondant au recuit effectué selon l'invention et correspondant à la courbe 53 de la figure 5).

On précise que si les exemples ci-dessus ont été décrits en référence à un décollement permettant de générer un SOI, l'invention s'applique au décollement de toute structure comportant une surface de fragilisation permettant de délimiter des couches à décoller.

## Revendications

1. Procédé de décollement de deux couches de matériau selon une surface de fragilisation définie entre les deux couches, le procédé comprenant un recuit thermique d'une structure (10) comprenant lesdites couches, le recuit amenant la température d'une température de début de recuit à une température de fin de recuit, **caractérisé en ce que** lors du recuit thermique on fait évoluer la température de recuit selon une première phase jusqu'à une température de transition, puis selon une deuxième phase lors de laquelle la croissance de la température par unité de temps est plus forte que lors de la première phase.

2. Procédé selon la revendication précédente, **caractérisé en ce que** la température de transition correspond à un début de décollement.

3. Procédé selon l'une des revendications précédentes, **caractérisé en ce que** la première phase est une phase d'initiation du décollement, et la deuxième phase est une phase de finition d'état de surface.

4. Procédé selon l'une des revendications précédentes, **caractérisé en ce que** la deuxième phase est suivie d'un palier de chauffage à une température sensiblement constante.

5. Procédé selon la revendication précédente, **caractérisé en ce que** ladite température sensiblement constante correspond à la température de fin de recuit.

6. Procédé selon l'une des revendications précédentes, **caractérisé en ce que** lors de la première phase la température augmente selon une pente moyenne lente, pouvant aller jusqu'à environ 10°C/min.

7. Procédé selon l'une des revendications précédentes, **caractérisé en ce que** lors de la deuxième phase la température augmente selon une pente moyenne rapide, supérieure à environ 15°C/min.

8. Procédé selon l'une des revendications précédentes, **caractérisé en ce que** la température de début de recuit est inférieure ou égale à 350°C.

9. Procédé selon l'une des revendications précédentes, **caractérisé en ce que** la température de fin de recuit est de l'ordre de 500°C à 800°C.

10. Procédé selon la revendication précédente **caractérisé en ce que** la température de fin de recuit est de l'ordre de 600°C.

11. Procédé selon l'une des revendications précédentes, **caractérisé en ce que** la température de transition entre les deux phases est de l'ordre de 430°C à 450°C.

12. Application d'un procédé selon l'une ou plusieurs des revendications précédente(s) pour décoller deux couches de matériau délimitées par une surface de fragilisation, ladite surface de fragilisation ayant été réalisée dans le cadre d'un procédé de type SMARTCUT^{®}.

13. Application selon la revendication précédente, **caractérisée en ce que** les deux couches de matériau comprennent une couche de silicium.

14. Application selon l'une des deux revendications précédentes, **caractérisée en ce que** les deux couches de matériau sont deux couches de silicium, une des deux couches correspondant à un SOI, l'autre couche correspondant à un reliquat de silicium.

## Claims

1. A method for delaminating two layers of material along an embrittlement surface defined between the two layers, the method including a thermal annealing of a structure (10) comprising said layers, wherein the annealing brings the temperature from an annealing start temperature to an annealing end temperature, **characterized in that** upon thermal annealing, the annealing temperature is made to evolve according to a first phase to a transition temperature, and then according to a second phase during which the temperature elevation per time unit is greater than during the first phase.

2. A method according to the preceding claim, **characterized in that** the transition temperature corresponds to a delamination start.

3. A method according to one of the preceding claims, **characterized in that** the first phase is a delamination initiation phase, and the second phase is a surface state finition phase.

4. A method according to one of the preceding claims, **characterized in that** the second phase is followed by a heating stage at a substantially constant temperature.

5. A method according to the preceding claim, **characterized in that** said substantially constant temperature corresponds to the annealing end temperature.

6. A method according to one of the preceding claims, **characterized in that** during the first phase, the temperature rises according to a slow average slope, which may reach about 10°C/min.

7. A method according to one of the preceding claims, **characterized in that** during the second phase, the temperature rises according to a fast average slope, greater than about 15°C/min.

8. A method according to one of the preceding claims, **characterized in that** the annealing start temperature is less than or equal to 350°C.

9. A method according to one of the preceding claims, **characterized in that** the annealing end temperature is in the order of 500°C to 800°C.

10. A method according to the preceding claim, **characterized in that** the annealing end temperature is in the order of 600°C.

11. A method according to one of the preceding claims, **characterized in that** the transition temperature between the two phases is in the order of 430°C to 450°C.

12. Application of a method according to one or more preceding claim(s) for delaminating two layers of material separated by an embrittlement surface, said embrittlement surface having been carried out during a SMARTCUT^{®}- type process.

13. Application according to the preceding claim, **characterized in that** the two layers of material include a silicon layer.

14. Application according to one of the two preceding claims, **characterized in that** the two layers of material are two silicon layers, one of the two layers corresponding to a SOI, the other layer corresponding to a silicon remainder.

## Patentansprüche

1. Verfahren zum Ablösen von zwei Materialschichten entlang einer zwischen den beiden Schichten definierten Schwächungsfläche, wobei das Verfahren ein thermisches Tempern einer Struktur (10) umfasst, die diese Schichten umfasst, und wobei das Tempern die Temperatur von einer Temperungs-Anfangstemperatur bis auf eine Temperungs-Endtemperatur führt, **dadurch gekennzeichnet, dass** beim thermischen Tempern die Temperungstemperatur in einer ersten Phase bis auf eine Übergangstemperatur verändert wird und dann in einer zweiten Phase verändert wird, in der die Temperaturzunahme pro Zeiteinheit stärker ist als in der ersten Phase.

2. Verfahren nach dem vorhergehenden Anspruch, **dadurch gekennzeichnet, dass** die Übergangstemperatur einem Beginn des Ablösens entspricht.

3. Verfahren nach einem der vorhergehenden Ansprüche, **dadurch gekennzeichnet, dass** die erste Phase eine Phase zur Einleitung des Ablösens ist und die zweite Phase eine Phase der Endbearbeitung des Oberflächenzustands ist.

4. Verfahren nach einem der vorhergehenden Ansprüche, **dadurch gekennzeichnet, dass** auf die zweite Phase eine Heizungsstufe bei einer im Wesentlichen konstanten Temperatur folgt.

5. Verfahren nach dem vorhergehenden Anspruch, **dadurch gekennzeichnet, dass** die im Wesentlichen konstante Temperatur der Temperungs-Endtemperatur entspricht.

6. Verfahren nach einem der vorhergehenden Ansprüche, **dadurch gekennzeichnet, dass** während der ersten Phase die Temperatur mit einer langsamen mittleren Steigung zunimmt, die bis etwa 10°C/min betragen kann.

7. Verfahren nach einem der vorhergehenden Ansprüche, **dadurch gekennzeichnet, dass** während der zweiten Phase die Temperatur mit einer schnellen mittleren Steigung zunimmt, die mehr als etwa 15°C/min beträgt.

8. Verfahren nach einem der vorhergehenden Ansprüche, **dadurch gekennzeichnet, dass** die Temperungs-Anfangstemperatur kleiner oder gleich 350°C ist.

9. Verfahren nach einem der vorhergehenden Ansprüche, **dadurch gekennzeichnet, dass** die Temperungs-Endtemperatur in etwa 500°C bis 800°C beträgt.

10. Verfahren nach dem vorhergehenden Anspruch, **dadurch gekennzeichnet, dass** die Temperungs-Endtemperatur bei etwa 600°C liegt.

11. Verfahren nach einem der vorhergehenden Ansprüche, **dadurch gekennzeichnet, dass** die Übergangstemperatur zwischen den beiden Phasen bei etwa 430°C bis 450°C liegt.

12. Anwendung eines Verfahrens gemäß einem oder mehreren der vorhergehenden Ansprüche zum Ablösen von zwei Materialschichten, die durch eine Schwächungsfläche abgegrenzt sind, wobei die Schwächungsfläche im Rahmen eines Verfahrens vom Typ SMARTCUT^{®} hergestellt wurde.

13. Anwendung nach dem vorhergehenden Anspruch, **dadurch gekennzeichnet, dass** die beiden Materialschichten eine Siliziumschicht umfassen.

14. Anwendung nach einem der beiden vorhergehenden Ansprüche, **dadurch gekennzeichnet, dass** die beiden Materialschichten zwei Siliziumschichten sind, wobei eine der beiden Schichten einer SOI-Schicht entspricht und die andere Schicht einer Siliziumrestmenge entspricht.
